# EUROPÄISCHE PATENTSCHRIFT

(11) **EP 4 154 244 B1**
(45) Veröffentlichungstag und Bekanntmachung des Hinweises auf die Patenterteilung: **15.01.2025**
(21) Anmeldenummer: 22754097.8
(22) Anmeldetag: 22.07.2022
(51) Int. Cl.: G10K 11/175, B60R 16/037

(54) **VERFAHREN ZUR MASKIERUNG VON UNERWÜNSCHTEN STÖRGERÄUSCHEN UND FAHRZEUG**
METHOD FOR MASKING UNWANTED INTERFERING SOUNDS AND VEHICLE
PROCÉDÉ DE MASQUAGE DE BRUITS PARASITES INDÉSIRABLES ET VÉHICULE

(30) Priorität: 10.08.2021 DE 102021004108
(43) Veröffentlichungstag der Anmeldung: 29.03.2023
(60) Teilanmeldung: 23176301.2
(73) Patentinhaber: Mercedes-Benz Group AG, 70372 Stuttgart (DE)
(72) Erfinder: KÜPPERS, Thomas, 71155 Altdorf (DE); LIESKE, Dirk, 70825 Korntal-Muenchingen (DE); TREIBER, Alexander, 71088 Holzgerlingen (DE)
(74) Vertreter: Novagraaf Group
(86) Internationale Anmeldenummer: PCT/EP2022/070657
(87) Internationale Veröffentlichungsnummer: WO 2023/016779

(56) Entgegenhaltungen:
- EP-A1- 3 757 986
- DE-A1- 102020 004 974
- US-A1- 2021 197 667

## Beschreibung

Die Erfindung betrifft ein Verfahren zur Maskierung von unerwünschten, während des Betriebes eines Fahrzeugs auftretenden Störgeräuschen, durch synthetische Geräusche nach der im Oberbegriff von Anspruch 1 näher definierten Art, sowie ein Fahrzeug zur Durchführung des Verfahrens.

Fahrzeuge geben während ihres Betriebs eine Vielzahl verschiedener Geräusche ab. So werden einige dieser Geräusche, beispielsweise ein knackiger Motoren- oder Auspuffsound, als angenehm empfunden, wohingegen andere Geräusche wie Klappern, Rattern, Brummen oder ein schleifender Keilriemen als unangenehm empfunden werden. Insbesondere bei elektrifizierten Fahrzeugen spielen die vom Fahrzeug abgegebenen Geräusche eine bedeutende Rolle für den Komfort bei der Nutzung des Fahrzeugs, sowie für die Sicherheit von Verkehrsteilnehmern. Dadurch, dass elektrifizierte Fahrzeuge meist leiser sind gegenüber einem Fahrzeug mit Verbrennungsmotor, sind elektrisch angetriebene Fahrzeuge von Verkehrsteilnehmern oftmals schlecht wahrnehmbar. So sind generell aus dem Stand der Technik bereits Verfahren und Vorrichtungen zur Erzeugung synthetischer Fahrzeuggeräusche bekannt. Mittels eines solchen synthetischen Fahrzeuggeräuschs wird beispielsweise eine Beschleunigung des entsprechenden Fahrzeugs vertont, wodurch zum einen Verkehrsteilnehmer vor dem elektrifizierten Fahrzeug gewarnt werden und zum anderen, durch das Generieren eines besonders futuristischen und angenehmen Motorsounds, ein Komfort für die fahrzeugführende Person des elektrifizierten Fahrzeugs gesteigert wird.

Typischerweise geben Elektromotoren mittel- und hochfrequente Schwingungen ab, welche nur bedingt durch typische Noise Vibration Harshness (NVH) Maßnahmen dämpfbar sind. Die durch die Vibrationen erzeugten Geräusche sind prinzipiell leise, aber durch ihre Tonalität und die Korrelation der Tonhöhe zur Drehzahl des Elektromotors bzw. zu einer Fahrzeuggeschwindigkeit, stark heraushörbar.

Beispielsweise ist aus der EP 3 514 790 A1 ein Verfahren nebst Vorrichtung zur Erzeugung eines synthetischen Geräuschs zur Vertonung einer Beschleunigung eines Fahrzeugs bekannt. Ein solches, mit der Beschleunigung des Fahrzeugs zusammenhängendes Geräusch, ist jedoch nur unzureichend zur Maskierung von Geräuschen, die nicht von der Beschleunigung des Fahrzeugs abhängen, geeignet.

Die DE 10 2020 004 974 A1 offenbart hingegen ein Verfahren zur Maskierung von unerwünschten, von einem Antriebsstrang eines Fahrzeugs erzeugten Geräuschen, welches zur Maskierung von Geräuschen, die nicht mit einer Beschleunigung des Fahrzeuges zusammenhängen, geeignet ist. Gemäß des in der Druckschrift offenbarten Verfahrens wird ein unmoduliertes synthetisches Geräusch durch Multiplikation mit einem von einem Fahrzeugparameter abhängigen Filter und einem von einem Fahrzeugparameter abhängigen Verstärker multipliziert und hierdurch moduliert, um ein besonders natürlich klingendes Geräusch zur Maskierung eines Störgeräuschs zu erzeugen. Dabei bleibt eine Tonhöhe sämtlicher akustischer Signale, aus denen sich das synthetische Geräusch zusammensetzt, konstant. Als Quelle für das unmodulierte synthetische Geräusch wird dabei insbesondere Breitbandrauschen, auch als weißes Rauschen bezeichnet, verwendet. Zur Erzeugung eines besonders natürlich klingenden synthetischen Geräuschs wird das synthetische Geräusch in seiner Klangcharakteristik so angepasst, dass es wie Windrauschen und/oder ein auf einer Oberfläche abrollender Reifen klingt. Nachteilig ist dabei jedoch, dass sich das synthetisch erzeugte Geräusch nicht in das Akustikverhalten des Fahrzeugs einbettet, sondern wie ein "Pflaster" zur Maskierung des unerwünschten Geräuschs wirkt. Somit ist kein komfortables Maskieren des unerwünschten Geräuschs möglich.

Aus der US 2021/197667 A1 ist ein Fahrzeug mit Ambisonic-Surround-Sound bekannt.

Die EP 3 757 986 A1 offenbart ein Verfahren zur Maskierung von Störgeräuschen eines Fahrzeuges mit dynamischer Erzeugung eines maskierenden Audiosignals auf der Grundlage von Antriebs- und Hintergrundgeräuschen.

Aus der DE 10 2020 004974 A1 ist ein Verfahren zur Maskierung von Störgeräuschen eines Fahrzeuges bekannt, welches eine Vormodulierung von einem Windrauschen entsprechend synthetischen Geräusch mit einem statischen Filter sowie die Modulierung mit einem adaptiven Verstärker umfasst. Bei dem Filter kann es sich um einen beliebigen Filter wie einen Tiefpass-, Hochpass- oder Bandpassfilter sowie beliebigen Kombinationen daraus handeln. Mit Hilfe des Filters werden akustische Signale, welche unerwünschte Frequenzen aufweisen, aus dem unmodulierten synthetischen Geräusch entfernt. Mit Hilfe des Verstärkers wird eine Lautstärke eines modulierten synthetischen Geräuschs vergrößert. Der Filter und der Verstärker sind adaptiv ausgeführt und passen sich an Fahrzeugparameter umfassende Eingangsgrößen an.

Der vorliegenden Erfindung liegt die Aufgabe zugrunde, ein verbessertes Verfahren zur Maskierung von unerwünschten, während des Betriebs eines Fahrzeugs auftretenden Störgeräuschen durch synthetische Geräusche anzugeben, mit dessen Hilfe ein Nutzerkomfort von Fahrzeuginsassen während des Betriebs des Fahrzeugs verbessert wird.

Erfindungsgemäß wird diese Aufgabe durch ein Verfahren zur Maskierung von unerwünschten, während des Betriebes eines Fahrzeugs auftretenden Störgeräuschen durch synthetische Geräusche mit den Merkmalen des Anspruchs 1 gelöst. Vorteilhafte Ausgestaltungen und Weiterbildungen sowie ein Fahrzeug zur Durchführung des Verfahrens ergeben sich aus den hiervon abhängigen Ansprüchen.

Bei einem Verfahren zur Maskierung von unerwünschten Störgeräuschen der eingangs genannten Art, wird erfindungsgemäß als Ausgangsquelle für ein unmoduliertes synthetisches Geräusch 1/f-Rauschen verwendet und vor einer Modulation des unmodulierten synthetischen Geräuschs durch den wenigstens einen vom Fahrzeugparameter abhängigen Filter und/oder Verstärker das unmodulierte synthetische Geräusch mittels wenigstens eines statischen Filters vormoduliert.

Mit Hilfe des Verfahrens ist das Erzeugen eines besonders natürlich klingenden synthetischen Geräuschs zur Maskierung von Störgeräuschen möglich. Dieses natürlich klingende synthetische Geräusch lässt sich besonders komfortabel in ein Akustikverhalten eines Fahrzeugs einbetten, sodass das synthetische Geräusch von Fahrzeuginsassen und fahrzeugexternen Verkehrsteilnehmern als besonders natürlich und Teil des Fahrzeugs wahrgenommen wird. Ein Kerngedanke ist dabei zum einen die Verwendung von 1/f-Rauschen als Ausgangsquelle für das unmodulierte synthetische Geräusch.

Unmoduliert bedeutet dabei, dass ein entsprechendes Ausgangssignal nicht manipuliert wurde. Bei 1/f-Rauschen, auch als rosa Rauschen bezeichnet, handelt es sich um ein Geräusch, welches im Frequenzraum betrachtet einer linear fallenden Funktion entspricht. Dies bedeutet, dass mit zunehmenden Frequenzen die Amplitude, sprich der Pegel der jeweiligen Frequenzen, abnimmt. In einer doppel-logarithmischen Auftragung weist 1/f-Rauschen eine negative Steigung von etwa 3dB pro Oktave auf. Beim weißen Rauschen hingegen ist die Amplitude des Geräuschs über sämtliche Frequenzen annähernd konstant. Für den Menschen klingt weißes Rauschen jedoch höhenbetont. Dies bedeutet, dass hohe Frequenzen vom Menschen stärker wahrgenommen werden. Da die Amplitude der hohen Frequenzen beim 1/f-Rauschen hingegen sinkt, wird 1/f-Rauschen als ein Geräusch empfunden, bei dem alle Frequenzbereiche des hörbaren Schallspektrums in etwa gleichlaut erklingen. Dies erlaubt das Erzeugen eines besonders natürlich klingenden synthetischen Geräuschs zur Maskierung von Störgeräuschen.

Mit Hilfe des statischen Filters wird das 1/f-Rauschen so moduliert, dass das mittels des statischen Filters vormodulierte synthetische Geräusch einen Peak in dem Frequenzbereich aufweist, in dem das zu maskierende Störgeräusch vorliegt. Die Übertragungsfunktion des statischen Filters ist konstant und somit unabhängig von jeglicher Beschleunigung und/oder Geschwindigkeit des Fahrzeugs oder von Antriebsstrangkomponenten des Fahrzeugs.

1/f-Rauschen ist eine normierte Standardfunktion und wird als einzige Signalquelle zur Ausbildung des unmodulierten synthetischen Geräuschs verwendet. Hierdurch wird ein Ressourcenbedarf an Rechenleistung und Speicherplatz zur Erzeugung des synthetischen Geräuschs auf ein Minimum reduziert. Beispielsweise kann das 1/f-Rauschen in Form einer WAV-Datei in einem Speicherelement wie einem Flash-Speicher abgelegt werden und das unmodulierte synthetische Geräusch aus der WAV-Datei gesampelt werden.

Ein mögliches, mit Hilfe des synthetischen Geräuschs zu maskierendes Störgeräusch, kann beispielsweise von einem Antriebsstrang des Fahrzeugs erzeugt werden. Insbesondere handelt es sich dabei um den Antriebsstrang eines zumindest teilelektrifizierten Fahrzeugs. Bei elektrifizierten Fahrzeugen kann es vorkommen, dass insbesondere der elektrifizierte Teil des Antriebsstrangs in einem bestimmten Geschwindigkeitsbereich, sprich zu einer bestimmten Drehzahl einer Antriebsstrangkomponente, einen Heulton mit einem festgelegten Frequenzspektrum erzeugt. Dieser Heulton ist störend und soll maskiert werden. Da die Erzeugung des Heultons von einer Rotationsgeschwindigkeit zumindest einer Komponente des Antriebsstrangs abhängig ist, tritt der Heulton auch in einem ganz bestimmten Fortbewegungsgeschwindigkeitsbereich des Fahrzeugs auf. Zur besonders komfortablen Maskierung des Störgeräuschs wird das synthetische Geräusch so in das Akustikverhalten des Fahrzeugs eingebettet, dass das synthetische Geräusch zur Maskierung in dem Fortbewegungsgeschwindigkeitsbereich des Fahrzeugs ausgegeben wird, in dem auch der Heulton auftritt.

Dabei gilt es, eine Lautstärke des synthetischen Geräuschs an die Lautstärke des zu übertönenden Störgeräuschs anzupassen. Ist das synthetische Geräusch zu leise, so ist das Störgeräusch weiterhin wahrnehmbar. Ist das synthetische Geräusch hingegen zu laut, so wird das synthetische Geräusch selbst gegebenenfalls von einem Fahrzeuginsassen als störend empfunden. Durch Multiplikation des vormodulierten synthetischen Geräuschs mit einem Verstärker lässt sich die Lautstärke des synthetischen Geräuschs gezielt auf eine Soll-Lautstärke einstellen.

Das erfindungsgemäße Verfahren sieht vor, dass das unmodulierte synthetische Geräusch mittels des wenigstens einen statischen Filters so vormoduliert wird, dass das vormodulierte synthetische Geräusch wenigstens zwei akustische Signale umfasst, wobei ein erstes akustisches Signal eine erste spektrale Breite aufweist, ein zweites akustisches Signal eine zweite spektrale Breite aufweist und die erste spektrale Breite einem Frequenzbereich von 0 bis maximal 2200 Hz entspricht und die zweite spektrale Breite in einem zur ersten spektralen Breite höheren Frequenzbereich liegt, wobei die zweite spektrale Breite eine spektrale Breite zumindest eines zu maskierenden Störgeräuschs vollständig umfasst. Indem das vormodulierte synthetische Geräusch so erzeugt wird, dass es zumindest das erste und zweite akustische Signal umfasst, wird eine natürlich klingende Wahrnehmbarkeit des synthetischen Geräuschs verbessert. Durch die tieffrequenten Anteile klingt das synthetische Geräusch nach einem besonders natürlichen Wind- und/oder Rollgeräusch. Hierdurch wird ein Komfort für die Insassen des Fahrzeugs während des Betriebs des Fahrzeugs noch weiter verbessert. Die erste spektrale Breite kann dabei eine beliebige Breite innerhalb des Frequenzbereichs von 0 bis 2200 Hz annehmen. Beispielsweise kann die erste spektrale Breite einen Wert von 0 bis 500 Hz, 0 bis 1500 Hz, 200 bis 600 Hz oder 1700 bis 2200 Hz annehmen. Über die erste spektrale Breite lässt sich ein Klang eines "Grundrauschen" des Wind- bzw. Rollgeräuschs gezielt einstellen.

Die zweite spektrale Breite umfasst zumindest den Frequenzbereich, in dem das zu maskierende Störgeräusch auftritt. In einem an das zu maskierende Störgeräusch angrenzenden Frequenzbereich, beispielsweise ±100 Hz, kann die Amplitude des zweiten akustischen Signals graduell abfallen bzw. ansteigen. Dies unterstützt den natürlichen Klang des synthetischen Geräuschs noch weiter.

Entsprechend einer vorteilhaften Weiterbildung des erfindungsgemäßen Verfahrens wird wenigstens ein adaptives Filter von einem Tiefpassfilter ausgebildet, wobei eine Grenzfrequenz des Tiefpassfilters von einer Fortbewegungsgeschwindigkeit des Fahrzeugs abhängt. Mit Hilfe des Tiefpassfilters lässt sich der natürliche Klang des synthetischen Geräuschs noch weiter verbessern. So ist ein natürliches Wind- bzw. Rollgeräusch eines Fahrzeugs von der Fortbewegungsgeschwindigkeit des Fahrzeugs abhängig. Mit zunehmender Fortbewegungsgeschwindigkeit nimmt auch ein Anteil an hohen Frequenzen im Wind- bzw. Rollgeräusch zu. Der Tiefpassfilter ist als adaptiver Filter ausgebildet und von der Fortbewegungsgeschwindigkeit des Fahrzeugs abhängig. Die Grenzfrequenz des Tiefpassfilters wird mit zunehmender Fortbewegungsgeschwindigkeit des Fahrzeugs zu hohen Frequenzen verschoben. Die Tonhöhe der akustischen Signale des modulierten synthetischen Geräuschs bleibt konstant, jedoch lässt sich mit Hilfe des Tiefpassfilters steuern, bis zu welcher Frequenz akustische Signale, sprich Töne, in das modulierte synthetische Geräusch integriert werden sollen. So lassen sich mit steigender Fortbewegungsgeschwindigkeit des Fahrzeugs auch mehr Töne mit höherer Frequenz aufnehmen. Somit lässt sich die Klangcharakteristik des modulieren synthetischen Geräuschs an ein besonders natürlich klingendes Wind- bzw. Rollgeräusch anpassen.

Eine weitere vorteilhafte Ausgestaltung des erfindungsgemäßen Verfahrens sieht ferner vor, dass ein Verstärkungsfaktor zumindest eines adaptiven Verstärkers von einer Fortbewegungsgeschwindigkeit des Fahrzeugs abhängt, wobei der Verstärkungsfaktor in zumindest einem Geschwindigkeitsbereich, in dem ein Störgeräusch auftritt, einen maximalen Wert annimmt. Wie bereits erwähnt lässt sich mit Hilfe eines Verstärkers die Lautstärke des modulierten synthetischen Geräuschs anpassen. Der Verstärkungsfaktor des adaptiven Verstärkers wird dabei an die Fortbewegungsgeschwindigkeit des Fahrzeugs gekoppelt. In einem Geschwindigkeitsbereich, in dem das zu maskierende Störgeräusch nicht auftritt, liegt dieser Verstärkungsfaktor bevorzugt bei 0 oder einem sehr geringen Wert wie 0,01. In dem Fortbewegungsgeschwindigkeitsbereich, in dem das zu maskierende Störgeräusch auftritt, liegt der Verstärkungsfaktor des Verstärkers hingegen insbesondere bei 1 oder darüber.

Entsprechend einer weiteren vorteilhaften Ausgestaltung des Verfahrens nimmt der Verstärkungsfaktor in einem vorgegebenen Abstand vor Beginn und nach Ende des Geschwindigkeitsbereichs, in dem das Störgeräusch auftritt, einen minimalen Wert an, und steigt insbesondere kontinuierlich vom minimalen Wert auf den maximalen Wert an bzw. fällt ab. Mit anderen Worten wird die Lautstärke des modulierten synthetischen Geräuschs zur Maskierung des Störgeräuschs mit zunehmender Fortbewegungsgeschwindigkeit des Fahrzeugs sanft angehoben und beim Austritt aus dem Geschwindigkeitsbereich, in dem das Störgeräusch vorliegt, auch wieder sanft abgesenkt. Hierdurch lässt sich das synthetische Geräusch zur Maskierung des Störgeräuschs besonders komfortabel in das Akustikverhalten des Fahrzeugs einbetten. Das modulierte synthetische Geräusch lässt sich somit nahtlos in das im Fahrzeuginnenraum von den Fahrzeuginsassen wahrnehmbare Wind- bzw. Rollgeräusch einfügen. Während der Nutzung des Fahrzeugs kommt es somit nur zu einer minimalen Anhebung des Gesamtpegels im Fahrzeuginnenraum. Diese Anhebung beschränkt sich dabei auch nur auf den problematischen Geschwindigkeitsbereich des Fahrzeugs. Die Fahrzeuginsassen empfinden das synthetische Geräusch somit als ganz besonders authentisch. Besonders bevorzugt beginnt das synthetische Geräusch 10km/h vor dem eigentlichen Auftreten des Störgeräuschs lauter zu werden und nimmt auch 10km/h nach Abflauen des Störgeräuschs seine minimale Lautstärke wieder an. Durch diese sanfte Integration des synthetischen Geräuschs in das Akustikverhalten des Fahrzeugs, erscheint das synthetische Geräusch noch natürlicher.

Eine weitere vorteilhafte Ausgestaltung des erfindungsgemäßen Verfahrens sieht ferner vor, dass das synthetische Geräusch nach der Modulation durch das wenigstens eine adaptive Filter und/oder einen Verstärker vorzugsweise eingerichtet zur Einstellung einer Dämpfung (relativer Lautstärkepegel des rückgeführten Signals) eine Feedback-Verzögerung erfährt, dessen Übertragungsfunktion einem Kammfilter entspricht. Durch das Aufprägen einer Feedback-Verzögerung auf das synthetische Geräusch kann ein natürlicher Klang des synthetischen Geräuschs noch weiter gesteigert werden. Zum Aufprägen der Feedback-Verzögerung ist vergleichsweise wenig Rechenaufwand notwendig. Ferner lässt sich ein leichtes Flanging, das heißt Aufprägen von Nichtlinearitäten, im synthetischen Geräusch erzeugen. Der Pegel der Rückführung muss dabei kleiner als 0 dB sein, da es sonst zu Instabilitäten kommt. Dieser Dämpfungspegel kann dabei im Fahrzeug einstellbar sein. Dies ermöglicht es den Fahrzeuginsassen, bzw. einem autorisierten Techniker, den Klang des synthetischen Geräuschs in Abhängigkeit persönlicher Präferenzen einzustellen. Mit Hilfe der Feedback-Verzögerung lässt sich das Erkennen wiederholender Muster erschweren. Da das menschliche Ohr sehr gut dazu in der Lage ist wiederholende Muster zu erkennen, lässt sich hierdurch der natürliche Klang des synthetischen Geräuschs weiter verbessern. Insbesondere erfährt das synthetische Geräusch mehrmals die Feedback-Verzögerung.

Entsprechend einer weiteren vorteilhaften Ausgestaltung des Verfahrens wird dem synthetischen Geräusch in der Feedback-Verzögerung eine zu einer Frequenz des zu maskierenden Störgeräuschs reziproke Verzögerungszeit aufgeprägt. Die entsprechende Übertragungsfunktion weist somit die Gleichung Verzögerungszeit = 1/Frequenz auf. Die Übertragungsfunktion kann dabei auch so angepasst werden, dass eine Multiplikation mit dem Vielfachen der Frequenz 1/(n*f) erfolgt, also beispielsweise 1/(2 x f). Der Multiplikationsfaktor n wird idealerweise aus einem Zahlenraum von 2^{x} übernommen, wobei X positive oder negative Ganzzahlen beinhaltet. Der Faktor n hat damit idealerweise beispielsweise Werte von 0,25, 0,5, 1, 2, 4 etc. Dadurch wird akustisch gesehen die Übertragungsfunktion des Kammfilters auf Oktaven der Störfrequenz eingestellt, was der Natürlichkeit des synthetischen Verdeckungsgeräusches zuträglich ist. Auch die eingestellte Frequenz f lässt sich frei im Fahrzeug einstellen und muss sich nur grob nach der Frequenz des zu verdeckenden Störgeräusches richten. In die Formel zur Berechnung der Verzögerungszeit, die reziprok zur eingestellten Frequenz ist, kann auch eine Varianz eingehen. So kann die Formel beispielsweise lauten: Verzögerungszeit = 1/(Frequenz + Varianz) oder Verzögerungszeit = 1/(Frequenz - Varianz). Auch können gleichzeitig Multiplikationsfaktoren und Varianzen verwendet werden, also beispielsweise Verzögerungszeit = 1/(N*Frequenz +/- Varianz). Liegt die dominante Frequenz in der ein Störgeräusch auftritt beispielsweise in einem Bereich um 3500Hz, so kann die Varianz beispielsweise 500Hz, oder Bruchteile oder Vielfache davon betragen.

Eine weitere vorteilhafte Ausgestaltung des erfindungsgemäßen Verfahrens sieht ferner vor, dass wenigstens ein synthetisches Geräusch zur Ausgabe im Fahrzeug auf wenigstens zwei Lautsprecher aufgeteilt wird. Indem das synthetische Geräusch auf wenigstens zwei Lautsprecher, bevorzugt mehr als zwei Lautsprecher, aufgeteilt wird, lässt sich seine Quelle für Fahrzeuginsassen schwer lokalisieren. Hierdurch scheint das synthetische Geräusch aus verschiedenen Richtungen zu kommen, was den natürlichen Klang weiter verbessert.

Entsprechend einer weiteren vorteilhaften Ausgestaltung des Verfahrens wird das wenigstens eine synthetische Geräusch über wenigstens zwei Lautsprecher so ausgegeben, dass eine Position einer scheinbaren Geräuschquelle, aus der das synthetische Geräusch für einen Fahrzeuginsassen zu kommen scheint, in einem Fahrzeuginnenraum an einem festgelegten Ort positioniert wird, insbesondere unter Anwendung eines Ambisonics-Algorithmus. Durch einen leichten Zeitversatz in der Ausgabe des synthetischen Geräuschs zwischen den wenigstens zwei Lautsprechern wird es ermöglicht, eine Position einer scheinbaren Geräuschquelle, aus der das synthetische Geräusch für einen Fahrzeuginsassen zu kommen scheint, frei im Fahrzeuginnenraum zu positionieren. Besonders bevorzugt werden hierzu mehr als zwei Lautsprecher, beispielsweise drei, vier oder fünf Lautsprecher verwendet. Dabei wird der Zeitversatz der Ausgabe des synthetischen Geräuschs individuell für jeden der Lautsprecher bestimmt. Zur noch besseren Applikation von Verzögerungszeiten und Lautsprecherausgabepegeln wird besonders bevorzugt ein Ambisonics-Algorithmus verwendet. Bei Ambisonics handelt es sich um ein Verfahren zur Aufnahme und/oder Wiedergabe eines Klangfelds. Ambisonics ermöglicht ein besonders einfaches und komfortables Platzieren von virtuellen, also scheinbaren Geräuschquellen im Raum. Somit ist ein Entwickler dazu in der Lage, die Position, aus der das synthetische Geräusch zu kommen scheint, relativ zum Fahrzeug festzulegen. So scheint das synthetische Geräusch für die Fahrzeuginsassen nicht mehr aus den entsprechenden Lautsprechern zu kommen, sondern stattdessen beispielsweise von einer fiktiven Schallquelle hinter einem Armaturenbrett des Fahrzeugs, aus Richtung der Fahrzeugaußenspiegel oder dergleichen. Dadurch, dass die Fahrzeuginsassen das synthetische Geräusch nicht aus Richtung der Lautsprecher wahrnehmen, sondern aus einer beliebigen anderen Richtung, erscheint das synthetische Geräusch als noch natürlicher zum Fahrzeug zu gehören.

Eine weitere vorteilhafte Ausgestaltung des erfindungsgemäßen Verfahrens sieht ferner vor, dass wenigstens zwei mit einer Feedback-Verzögerung versehene synthetische Geräusche im Fahrzeug ausgegeben werden und die scheinbaren Positionen ihrer Geräuschquellen an unterschiedlichen Orten im Fahrzeuginnenraum positioniert werden, wobei die beiden synthetischen Geräusche eine zueinander abweichende Feedback-Verzögerungszeit aufweisen. Hierdurch wird der natürliche Klang des synthetischen Geräuschs noch weiter verbessert. Die beiden synthetischen Geräusche können abgesehen von ihrer Feedback-Verzögerung auch identisch sein. Die beiden synthetischen Geräusche können sich jedoch auch in ihrer Frequenzbandbreite zumindest teilweise unterscheiden.

Bei einem Fahrzeug mit einer Recheneinheit, wenigstens einem Sensor zur Erfassung einer Fahrzeuggeschwindigkeit und wenigstens einem Lautsprecher, sind erfindungsgemäß die Recheneinheit, der Sensor und der Lautsprecher zur Durchführung eines im vorigen beschriebenen Verfahrens eingerichtet. Bei dem Fahrzeug kann es sich um ein beliebiges Fahrzeug wie einen Pkw, Lkw, Transporter, Bus oder dergleichen handeln. Die Recheneinheit umfasst Hardware und Software zur Realisierung des erfindungsgemäßen Verfahrens. So umfasst die Recheneinheit wenigstens ein Speicherelement, beispielsweise einen Flash-Speicher, zum Bevorraten einer zur Ausbildung des 1/f-Rauschen verwendeten Sounddatei und/oder Programmcode, dessen Ausführung auf einem Prozessor die Durchführung des erfindungsgemäßen Verfahrens erlaubt. Einzelne Signalverarbeitungselemente wie Filter und/oder Verstärker können von Hardwarekomponenten und/oder von Software ausgebildet werden. Der Sensor ermöglicht zumindest das Erfassen der Fahrzeuggeschwindigkeit. Somit kann eine Lautstärke des synthetischen Geräuschs in Abhängigkeit der Fahrzeuggeschwindigkeit angepasst werden, sodass das synthetische Geräusch mit ausreichender Lautstärke genau dann ausgegeben wird, wenn auch das zu maskierende Störgeräusch auftritt. Das synthetische Geräusch zur Maskierung zumindest eines Störgeräuschs wird dabei über wenigstens einen Lautsprecher, bevorzugt über mehrere Lautsprecher, ausgegeben. Die Lautsprecher können im Fahrzeug beliebig angeordnet sein.

Es können auch mehrere Störgeräusche während des Betriebs des Fahrzeugs auftreten, wobei insbesondere die verschiedenen Störgeräusche zu unterschiedlichen Fortbewegungsgeschwindigkeiten des Fahrzeugs auftreten. Mit Hilfe des erfindungsgemäßen Verfahrens lassen sich sämtliche auftretenden Störgeräusche individuell maskieren. Entsprechend werden mit Hilfe des erfindungsgemäßen Verfahrens verschiedene synthetische Geräusche erzeugt.

Besonders bevorzugt verfügt das Fahrzeug über einen zumindest teilelektrifizierten Antriebsstrang. Das Fahrzeug ist somit als Hybridfahrzeug oder rein batterieelektrisch angetriebenes Fahrzeug ausgeführt. Insbesondere bei einem elektrifizierten Antriebsstrang treten in verschiedenen Betriebspunkten Heulgeräusche auf, welche mit Hilfe des erfindungsgemäßen Verfahrens besonders komfortabel maskiert werden können.

Weitere vorteilhafte Ausgestaltungen des erfindungsgemäßen Verfahrens zur Maskierung von unerwünschten Störgeräuschen und des Fahrzeugs ergeben sich auch aus den Ausführungsbeispielen, welche nachfolgend unter Bezugnahme auf die Figuren näher beschrieben werden.

Dabei zeigen:
- Fig. 1: eine Prinzipdarstellung mehrerer Diagramme von während des Betriebs eines Fahrzeugs auftretenden Geräuschen in einem Frequenzraum;
- Fig. 2: eine Prinzipdarstellung einer erfindungsgemäßen Verarbeitung eines synthetischen Geräuschs; und
- Fig. 3: eine Draufsicht auf ein erfindungsgemäßes Fahrzeug, bei dem im Betrieb auftretende Störgeräusche mit Hilfe eines erfindungsgemäßen Verfahrens maskiert werden.

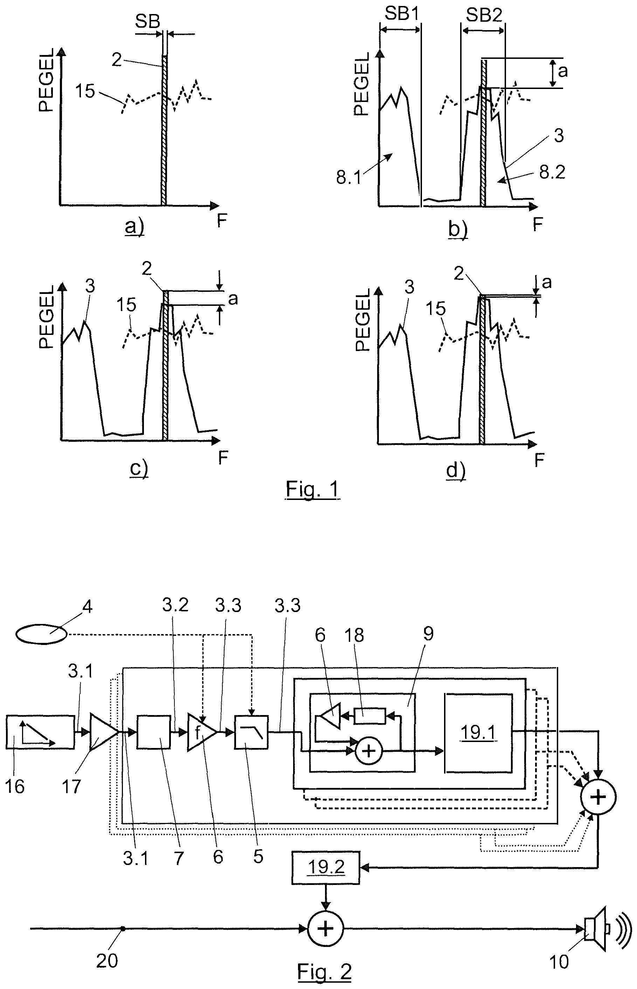

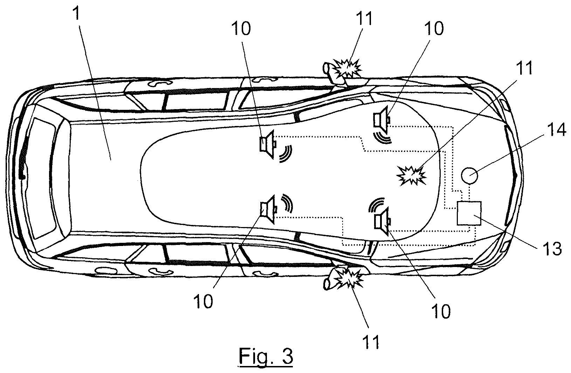

Figur 1 zeigt vier verschiedene Akustikdiagramme, in denen eine Lautstärke PEGEL von verschiedenen Geräuschen über eine Frequenz F aufgetragen ist. Dabei zeigt Figur 1a) ein in einem bestimmten Betriebspunkt während des Betriebs eines in Figur 3 gezeigten Fahrzeugs 1 auftretendes Störgeräusch 2, sowie ein während des Betriebs vorliegendes Hintergrundgeräusch 15. Das Störgeräusch 2 tritt in einem ebenfalls in Figur 3 gezeigten Fahrzeuginnenraum 12 wahrnehmbar in Erscheinung, wenn sich das Fahrzeug 1 mit einer in einem bestimmten Geschwindigkeitsbereich liegenden Fortbewegungsgeschwindigkeit fortbewegt, beispielsweise zwischen 110km/h - 120km/h. Das Störgeräusch 2 weist eine vergleichsweise schmale spektrale Breite SB auf, umfasst also nur einige wenige akustische Signale mit einer jeweils charakteristischen Frequenz F, und kann somit als störendes "Heulgeräusch" empfunden werden. Das Störgeräusch 2 wird insbesondere von einem elektrifizierten Teil eines Antriebsstrangs des Fahrzeugs 1 emittiert.

Zur Verbesserung eines Komforts von Fahrzeuginsassen während des Betriebs des Fahrzeugs 1 wird mit Hilfe eines erfindungsgemäßen Verfahrens ein in Figur 1b) gezeigtes synthetisches Geräusch 3 zur Maskierung des Störgeräuschs 2 erzeugt. Das synthetische Geräusch 3 zeichnet sich durch einen besonders natürlichen Klang aus und ist so in ein Akustikverhalten des Fahrzeugs 1 eingebettet, dass das synthetische Geräusch 3 im Betrieb des Fahrzeugs 1 nicht als "Pflaster" zum Übertönen des Störgeräuschs 2 heraussticht, sondern sich nahtlos in die im Fahrzeuginnenraum 12 wahrnehmbare Klangkulisse einfügt. Insbesondere klingt das synthetische Geräusch 3 dabei wie ein Wind- und/oder Rollgeräusch eines Reifens auf einer Fahrbahn. Das synthetische Geräusch 3 weist zu der spektralen Breite SB des Störgeräuschs 2 einen maximalen Lautstärkewert auf, was in Figur 1b) durch einen Peak zu erkennen ist. In Figur 1b) weist die maximale Lautstärke zwischen synthetischem Geräusch 3 und Störgeräusch 2 einen vergleichsweise großen Abstand a auf, was dazu führt, dass das synthetische Geräusch 3 zum ausreichenden Maskieren des Störgeräuschs 2 zu leise ist.

Besonders bevorzugt umfasst das synthetische Geräusch 3 wenigstens zwei akustische Signale 8.1 und 8.2. Das erste akustischen Signal 8.1 liegt im niederfrequenten Bereich und dient zur Ausbildung eines besonders natürlich klingenden Hintergrundrauschens. Hierzu weist das erste akustische Signal 8.1 eine vergleichsweise große erste spektrale Breite SB1 auf. Das zweite akustische Signal 8.2 dient zur Maskierung des Störgeräuschs 2 und weist dementsprechend eine zweite spektrale Breite SB2 auf, welche an die spektrale Breite SB des Störgeräuschs 2 angepasst ist.

In Figur 1c) wurde die Lautstärke PEGEL des synthetischen Geräuschs 3 angehoben, wodurch der Abstand a abgenommen hat. Hierdurch wird eine aus Komfortsicht optimale Maskierung des Störgeräuschs 2 erreicht.

In Figur 1d) hingegen wurde die Lautstärke PEGEL des synthetischen Geräuschs 3 zu stark angehoben. Aufgrund dieser Überkompensation besteht dann die Gefahr, dass das synthetische Geräusch 3 selbst wiederum im Fahrzeuginnenraum 12 als nicht zur natürlichen Klangkulisse des Fahrzeugs 1 gehörend, und damit als störend empfunden werden kann.

Für eine optimale Maskierung sollte die Lautstärke PEGEL des synthetischen Geräuschs 3 also ausreichend hoch, aber nicht zu laut sein. So reicht eine knapp unterhalb der Lautstärke PEGEL des Störgeräuschs 2 liegende Lautstärke PEGEL bereits aus, um einen optimalen psychoakustischen Pegelabstand zwischen Störgeräusch 2 und synthetischem Geräusch 3 zu erreichen.

Figur 2 dient zur Veranschaulichung, wie das synthetische Geräusch 3 erzeugt wird. So wird von einer Signalquelle 16 ein akustisches Signal 8 in Form von 1/f-Rauschen, auch als rosa Rauschen bezeichnet, bereitgestellt. Die Signalquelle 16 kann das 1/f-Rauschen beispielsweise als WAV-Datei umfassen, woraufhin ein unmoduliertes synthetisches Geräusch 3.1 durch Samplen erzeugt wird. Das unmodulierte synthetische Geräusch 3.1 kann optional nach der Erzeugung mit einem statischen Verstärker 17 in seiner Lautstärke verändert werden.

Anschließend wird das unmodulierte synthetische Geräusch 3.1 mit einem statischen Filter 7 multipliziert. Das statische Filter 7 kann von einem beliebigen Signalfilter ausgebildet sein oder beliebige Kombinationen davon umfassen. Beispielsweise handelt es sich beim statischen Filter 7 um einen Tiefpassfilter, Hochpassfilter, Bandpassfilter, Kammfilter oder Kombinationen daraus. Mittels des statischen Filters 7 wird das unmodulierte synthetische Geräusch 3.1 vormoduliert und in ein vormoduliertes synthetisches Geräusch 3.2 gewandelt, um dem synthetischen Geräusch 3 zumindest den Peak in der spektralen Breite SB, in der das Störgeräusch 2 auftritt, aufzuprägen. Da sich die spektrale Breite SB des Störgeräuschs 2 während des Betriebs des Fahrzeugs 1 nicht oder nur marginal ändert, reicht ein statisches Filter 7 zum Aufprägen des Peaks bereits aus. Die vom Störgeräusch 2 umfassten Frequenzen lassen sich beispielsweise in der Entwicklung des Fahrzeugs 1 mit Hilfe akustischer Messungen bestimmen und das statische Filter 7 entsprechend einstellen.

Bevorzugt wird das synthetische Geräusch 3 so vormoduliert, dass es neben dem Peak zu den Frequenzen des Störgeräuschs 2 auch noch einen niederfrequenten Anteil umfasst, also neben dem zweiten akustischen Signal 8.2 auch noch das erste akustische Signal 8.1 umfasst. Mit Hilfe von im tieffrequenten Bereich, in einem Bereich von 0 bis 2200Hz liegenden akustischen Signalen, wird der natürliche Klang des synthetischen Geräuschs 3 verbessert. So kann erreicht werden, dass das im Fahrzeuginnenraum 12 ausgegebene Geräusch mehr nach einem natürlichen Wind- und/oder Rollgeräusch klingt.

Das unmodulierte synthetische Geräusch 3.1 kann auch auf mehrere Signalpfade aufgeteilt werden, wobei jedem Signalpfad ein unterschiedliches statisches Filter 7 zugeordnet ist (nicht dargestellt). Anschließend werden die einzelnen Signale wieder zusammengeführt.

Im Anschluss an das statische Filter 7 erfährt das vormodulierte synthetische Geräusch 3.2 eine Multiplikation mit wenigstens einem adaptiven Verstärker 6 und/oder wenigstens einem adaptiven Filter 5 und wird hierdurch in ein moduliertes synthetisches Geräusch 3.3 gewandelt. Ein Verstärkungsfaktor f des adaptiven Verstärkers 6 ist von einem Fahrzeugparameter 4 abhängig. Bei dem Fahrzeugparameter 4 handelt es sich um einen von einer Fortbewegungsgeschwindigkeit des Fahrzeugs 1 abhängigen Parameter. Beispielsweise kann es sich bei dem Fahrzeugparameter 4 um eine Drehzahl eines Reifens, einer Welle oder dergleichen, oder auch um die Fortbewegungsgeschwindigkeit selbst handeln.

Mit Hilfe des adaptiven Verstärkers 6 wird eine Ausgabe des synthetischen Geräuschs 3 im Fahrzeuginnenraum 12 so gesteuert, dass das synthetische Geräusch 3 ausschließlich in dem Geschwindigkeitsbereich ausgegeben wird, in dem auch das Störgeräusch 2 auftritt, Plus/Minus eines gewissen Geschwindigkeitsübergangsbereich. So weist das synthetische Geräusch 3 in dem Geschwindigkeitsbereich zu dem das Störgeräusch 2 auftritt, also beispielsweise im Bereich zwischen 110km/h bis 120km/h, auch seine maximale Lautstärke auf. Im Geschwindigkeitsübergangsbereich, beispielsweise +/-5km/h, 10km/h, 20km/h oder dergleichen, über, beziehungsweise unter 110km/h, beziehungsweise 120km/h, wird dann die Lautstärke des synthetischen Geräuschs 3 graduell angehoben, beziehungsweise abgesenkt. Das Anheben und Absenken der Lautstärke des synthetischen Geräuschs 3 erfolgt dabei so, dass das synthetische Geräusch 3 für die Fahrzeuginsassen als besonders natürlich und als Teil des Akustikverhaltens des Fahrzeugs 1 erscheint. Beispielsweise wird die Lautstärke des synthetischen Geräuschs im Geschwindigkeitsübergangsbereich linear oder parabelförmig angehoben und abgesenkt.

Ferner kann das vormodulierte synthetische Geräusch 3.2 oder das bereits durch den adaptiven Verstärker 6 modulierte synthetische Geräusch 3.3 mit einem adaptiven Filter 5 multipliziert werden. Bei dem adaptiven Filter 5 kann es sich, analog zum statischen Filter 7, um eine beliebige Kombination aus typischen Signalfiltern handeln. Besonders bevorzugt umfasst das adaptive Filter 5 zumindest einen Tiefpassfilter. Der adaptive Filter 5 ist ebenfalls von dem Fahrzeugparameter 4 abhängig. Beispielsweise wird die Grenzfrequenz des Tiefpassfilters in Abhängigkeit der Fortbewegungsgeschwindigkeit des Fahrzeugs 1 gewählt. Besonders bevorzugt erfolgt dabei eine proportionale Anpassung der Grenzfrequenz mit der Fortbewegungsgeschwindigkeit. Fährt das Fahrzeug 1 also schneller, so werden auch mehr hochfrequente Anteile in das modulierte synthetische Geräusch 3.3 integriert. Dabei bleibt die Tonhöhe der einzelnen akustischen Signale des synthetischen Geräuschs 3 während des Betriebs des Fahrzeugs 1 konstant. Es werden lediglich mehr oder weniger akustische Signale aus dem hochfrequenten Bereich in das synthetische Geräusch 3 eingebaut. Hierdurch wird dem Rechnung getragen, dass ein natürlich klingendes Wind- bzw. Rollgeräusch mit zunehmender Fortbewegungsgeschwindigkeit des Fahrzeugs 1 auch mehr hochfrequente Anteile umfasst. Hierdurch kann der natürliche Klang des synthetischen Geräuschs 3 noch weiter verbessert werden.

Anschließend wird dem modulierten synthetischen Geräusch 3.3 durch ein Feedback-Verzögerungsmodul 9 eine Feedback-Verzögerung aufgeprägt. Eine Verzögerungszeit kann dabei mittels eines Verzögerungsblocks 18 eingestellt werden. Besonders bevorzugt beträgt die Verzögerungszeit einem Kehrwert einer besonders dominanten Frequenz F des Störgeräuschs 2. Der Pegel der Rückführung sollte zur Vermeidung von Instabilitäten kleiner als 0dB sein. Hierzu erfolgt eine Multiplikation mit einem Verstärker 6 dessen Verstärkungsfaktor f einen Wert kleiner als -0,01 dB aufweist. Dieser Wert kann frei im Fahrzeug 1 eingestellt werden.

Das synthetische Geräusch 3 kann auch mehrmals durch die Feedback-Verzögerung geführt werden. Eine Übertragungsfunktion der Feedback-Verzögerung kann auch einem Kammfilter ähneln oder von diesem ausgebildet sein.

In einer besonders vorteilhaften Ausführung wird wenigstens ein synthetisches Geräusch 3 über wenigstens zwei in Figur 3 gezeigte Lautsprecher 10 im Fahrzeuginnenraum 12 ausgegeben. Dabei wird aus dem oder den synthetischen Geräuschen 3 ein virtuelles Klangobjekt erzeugt, welches an einer beliebigen Stelle im Fahrzeuginnenraum 12, beziehungsweise auch außerhalb des Fahrzeugs 1, platziert werden kann. Somit scheint das oder die synthetischen Geräusche 3 nicht mehr direkt aus den Lautsprechern 10 zu kommen, sondern von einer Position einer oder mehreren scheinbaren Geräuschquellen 11. Zur Erzeugung des virtuellen Klangobjekts und freien Platzierung des Klangobjekts im Raum wird bevorzugt ein Ambisonics-Algorithmus eingesetzt. Hierzu wird zuerst das modulierte synthetische Geräusch 3.3 von einem Ambisonics-Encoder 19.1 und anschließend von einem Ambisonics-Decoder 19.2 verarbeitet.

Zur Erzeugung mehrerer im Fahrzeuginnenraum 12 auszugebender Geräusche, kann die Kombination aus Feedback-Verzögerungsmodul 9 und Ambisionics-Encoder 19.1 auch, wie durch die gestrichelten Boxen dargestellt, mehrmals vorgesehen sein. Existieren mehrere Störgeräusche 2, so können auch mehrere synthetische Geräusche 3 zur Maskierung der Störgeräusche 2 erzeugt werden, was durch die gepunkteten Boxen angedeutet ist. Zur Ausgabe der einzelnen synthetischen Geräusche 3 im Fahrzeuginnenraum 12 werden dann die einzelnen synthetischen Geräusche 3 zusammengeführt.

Das Fahrzeug 1 kann weitere nicht näher erläuterte Einrichtungen zur Erzeugung künstlicher Geräusche aufweisen. So wird beispielsweise ein künstliches Motorengeräusch 20 mit den im Fahrzeuginnenraum 12 auszugebenden synthetischen Geräuschen 3 kombiniert.

Figur 3 zeigt eine Draufsicht auf ein erfindungsgemäßes Fahrzeug 1. Das Fahrzeug 1 weist bevorzugt einen zumindest teilelektrifizierten Antriebsstrang auf. Im Fahrzeuginnenraum 12 sind mehrere Lautsprecher 10 zur Ausgabe wenigstens eines synthetischen Geräuschs 3 angeordnet. Besonders bevorzugt befindet sich zumindest ein Lautsprecher 10 in Fahrtrichtung des Fahrzeugs 1 vor einem Fahrzeuginsassen und zumindest ein Lautsprecher 10 hinter dem jeweiligen Fahrzeuginsassen. Somit kann ein besonders natürlich klingender Raumklang erzeugt werden. Besonders bevorzugt wird eine Position einer scheinbaren Geräuschquelle 11, aus der das synthetischen Geräuschs 3 zu kommen scheint, im Fahrzeuginnenraum 12 an einer Sollposition platziert. Dies erlaubt das freie platzieren der Geräuschquelle 11, sodass ein noch natürlicheres Klangerlebnis bei der Widergabe des synthetischen Geräuschs 3 ermöglicht wird. Beispielsweise wird ein synthetisches Geräusch 3 in einer Nähe zu den Außenspiegeln des Fahrzeugs platziert und ein synthetisches Geräusch 3 hinter einem Armaturenbrett des Fahrzeugs 1 verortet.

Zur Erfassung der Fortbewegungsgeschwindigkeit des Fahrzeugs 1 oder eines für die Fortbewegungsgeschwindigkeit repräsentativen Werts, umfasst das Fahrzeug 1 wenigstens einen Sensor 14. Die Erzeugung des synthetischen Geräuschs 3 erfolgt mittels einer Recheneinheit 13. Ein vom Sensor 14 erzeugter Messwert wird der Recheneinheit 13 als Eingangsgröße zugeführt, um die Lautstärke des synthetischen Geräuschs 3 in Abhängigkeit der Fortbewegungsgeschwindigkeit des Fahrzeugs 1 zu steuern und/oder bei steigender Fortbewegungsgeschwindigkeit mehr höherfrequente Anteile in das synthetische Geräusch 3 zu integrieren.

## Patentansprüche

1. Verfahren zur Maskierung von unerwünschten, während des Betriebs eines Fahrzeugs (1) auftretenden Störgeräuschen (2) durch synthetische Geräusche (3), wobei das synthetische Geräusch (3) aus einem unmodulierten synthetischen Geräusch (3.1) zum Einstellen einer gewünschten Klangcharakteristik durch eine Multiplikation mit wenigstens einem von einem Fahrzeugparameter (4) abhängigen Filter (5) und/oder Verstärker (6) erzeugt wird, wobei eine Tonhöhe sämtlicher akustischer Signale (8) aus denen sich das modulierte synthetische Geräusch (3.3) zusammensetzt, während einer Ausgabe des modulierten synthetischen Geräuschs (3.3) konstant gehalten wird,
**dadurch gekennzeichnet, dass**
das unmodulierte synthetische Geräusch (3.1) als 1/f-Rauschen ausgebildet und vor einer Modulation durch den wenigstens einen vom Fahrzeugparameter (4) abhängigen Filter (5) und/oder Verstärker (6) mittels wenigstens eines statischen Filters (7) vormoduliert wird, wobei
das unmodulierte synthetische Geräusch (3.1) mittels des wenigstens einen statischen Filters (7) so vormoduliert wird, dass das vormodulierte synthetische Geräusch (3.2) wenigstens zwei akustische Signale (8.1, 8.2) umfasst, wobei ein erstes akustisches Signal (8.1) eine erste spektrale Breite (SB1) aufweist, ein zweites akustisches Signal (8.2) eine zweite spektrale Breite (SB2) aufweist und die erste spektrale Breite (SB1) einem Frequenzbereich von 0 bis maximal 2200 Hz entspricht und die zweite spektrale Breite (SB2) in einem zur ersten spektralen Breite (SB1) höheren Frequenzbereich liegt, wobei die zweite spektrale Breite (SB2) eine spektrale Breite zumindest eines zu maskierenden Störgeräuschs (2) vollständig umfasst.

2. Verfahren nach Anspruch 1,
**dadurch gekennzeichnet, dass**
wenigstens ein adaptives Filter (5) von einem Tiefpassfilter ausgebildet wird, wobei eine Grenzfrequenz des Tiefpassfilters von einer Fortbewegungsgeschwindigkeit des Fahrzeugs (1) abhängt.

3. Verfahren nach einem der Ansprüche 1 bis 2,
**dadurch gekennzeichnet, dass**
ein Verstärkungsfaktor (f) zumindest eines adaptiven Verstärkers (6) von einer Fortbewegungsgeschwindigkeit des Fahrzeugs (1) abhängt, wobei der Verstärkungsfaktor (f) in zumindest einem Geschwindigkeitsbereich in dem ein Störgeräusch (2) auftritt, einen maximalen Wert annimmt.

4. Verfahren nach Anspruch 3,
**dadurch gekennzeichnet, dass**
der Verstärkungsfaktor (f) in einem vorgegebenen Abstand vor Beginn und nach Ende des Geschwindigkeitsbereichs in dem das Störgeräusch auftritt, einen minimalen Wert annimmt, und insbesondere kontinuierlich vom minimalen Wert auf den maximalen Wert ansteigt und abfällt.

5. Verfahren nach einem der Ansprüche 1 bis 4,
**dadurch gekennzeichnet, dass**
das synthetische Geräusch (3) nach der Modulation durch das wenigstens eine adaptive Filter (5) und/oder einen Verstärker (6) eine Feedback-Verzögerung, insbesondere mit einer einstellbaren Dämpfung, erfährt, dessen Übertragungsfunktion einem Kammfilter entspricht.

6. Verfahren nach Anspruch 5,
**dadurch gekennzeichnet, dass**
dem synthetischen Geräusch (3) in der Feedback-Verzögerung eine zu einer Frequenz (F) des zu maskierenden Störgeräusches (2) reziproke Verzögerungszeit aufgeprägt wird.

7. Verfahren nach einem der Ansprüche 1 bis 6,
**dadurch gekennzeichnet, dass**
wenigstens ein synthetisches Geräusch (3) zur Ausgabe im Fahrzeug (1) auf wenigstens zwei Lautsprecher (10) aufgeteilt wird.

8. Verfahren nach Anspruch 7,
**dadurch gekennzeichnet, dass**
das wenigstens eine synthetische Geräusch (3) über wenigstens zwei Lautsprecher (10) so ausgegeben wird, dass eine Position einer scheinbaren Geräuschquelle (11), aus der das synthetische Geräusch (3) für einen Fahrzeuginsassen zu kommen scheint, in einem Fahrzeuginnenraum (12) an einen festgelegten Ort positioniert wird, insbesondere unter Anwendung eines Ambisonics-Algorithmus.

9. Verfahren nach Anspruch 8,
**dadurch gekennzeichnet, dass**
wenigstens zwei mit einer Feedback-Verzögerung versehene synthetische Geräusche (3) im Fahrzeug (1) ausgegeben werden und die scheinbaren Positionen ihrer Geräuschquellen (11) an unterschiedlichen Orten im Fahrzeuginnenraum (12) positioniert werden, wobei die beiden synthetischen Geräusche (3) eine zueinander abweichende Feedback-Verzögerungszeit aufweisen.

10. Fahrzeug (1) mit einer Recheneinheit (13), wenigstens einem Sensor (14) zur Erfassung einer Fahrzeuggeschwindigkeit und wenigstens einem Lautsprecher (10), **dadurch gekennzeichnet, dass**
die Recheneinheit (13), der Sensor (14) und der Lautsprecher (10) zur Durchführung eines Verfahrens nach einem der Ansprüche 1 bis 9 eingerichtet sind.

## Claims

1. Method for masking unwanted background noises (2), occurring during operation of a vehicle (1), using synthetic noises (3), wherein the synthetic noise (3) is generated from an unmodulated synthetic noise (3.1) to adjust a desired sound characteristic by multiplication with at least one filter (5) and/or amplifier (6) dependent on a vehicle parameter (4), wherein a pitch level of all acoustic signals (8) of which the modulated synthetic noise (3.3) is composed is kept constant during an output of the modulated synthetic noise (3.3),
**characterized in that**
the unmodulated synthetic noise (3.1) is formed as 1/f noise and is pre-modulated by means of at least one static filter (7) before being modulated by the at least one filter (5) and/or amplifier (6) dependent on the vehicle parameter (4), wherein
the unmodulated synthetic noise (3.1) is pre-modulated by means of the at least one static filter (7) such that the pre-modulated synthetic noise (3.2) comprises at least two acoustic signals (8.1, 8.2), wherein a first acoustic signal (8.1) has a first spectral width (SB1), a second acoustic signal (8.2) has a second spectral width (SB2) and the first spectral width (SB1) corresponds to a frequency range from 0 to a maximum of 2200 Hz and the second spectral width (SB2) is in a higher frequency range than the first spectral width (SB1), wherein the second spectral width (SB2) completely comprises a spectral width of at least one background noise (2) to be masked.

2. Method according to claim 1,
**characterized in that**
at least one adaptive filter (5) is formed by a low-pass filter, wherein a cutoff frequency of the low-pass filter depends on a travel speed of the vehicle (1).

3. Method according to any of claims 1 to 2,
**characterized in that**
an amplification factor (f) of at least one adaptive amplifier (6) depends on a travel speed of the vehicle (1), wherein the amplification factor (f) assumes a maximum value in at least one speed range in which a background noise (2) occurs.

4. Method according to claim 3,
**characterized in that**
the amplification factor (f) assumes a minimum value at a predetermined distance before the start and after the end of the speed range in which the background noise occurs, and in particular continuously rises and falls from the minimum value to the maximum value.

5. Method according to any of claims 1 to 4,
**characterized in that**
the synthetic noise (3), after modulation by the at least one adaptive filter (5) and/or an amplifier (6), experiences a feedback delay, in particular with an adjustable attenuation, the transfer function of which corresponds to a comb filter.

6. Method according to claim 5,
**characterized in that**
a delay time reciprocal to a frequency (F) of the background noise (2) to be masked is applied to the synthetic noise (3) in the feedback delay.

7. Method according to any of claims 1 to 6,
**characterized in that**
at least one synthetic noise (3) is distributed to at least two loudspeakers (10) for output in the vehicle (1).

8. Method according to claim 7,
**characterized in that**
the at least one synthetic noise (3) is output via at least two loudspeakers (10) such that a position of an apparent noise source (11), from which the synthetic noise (3) appears to a vehicle occupant to originate, is positioned at a specified location in a vehicle interior (12), in particular using an ambisonics algorithm.

9. Method according to claim 8,
**characterized in that**
at least two synthetic noises (3) provided with a feedback delay are output in the vehicle (1) and the apparent positions of the noise sources (11) thereof are positioned at different locations in the vehicle interior (12), wherein the two synthetic noises (3) have a feedback delay time that differs from one another.

10. Vehicle (1) comprising a computing unit (13), at least one sensor (14) for detecting a vehicle speed, and at least one loudspeaker (10),
**characterized in that**
the computing unit (13), the sensor (14) and the loudspeaker (10) are designed to carry out a method according to any of claims 1 to 9.

## Revendications

1. Procédé pour le masquage des bruits parasites (2) non souhaités, apparaissant pendant le fonctionnement d'un véhicule (1), par des bruits synthétiques (3), le bruit synthétique (3) étant produit à partir d'un bruit synthétique non modulé (3.1) pour le réglage d'une caractéristique sonore souhaitée par une multiplication par au moins un filtre (5) et/ou un amplificateur (6) dépendant d'un paramètre (4) de véhicule, une hauteur de ton de tous les signaux acoustiques (8) qui composent le bruit synthétique modulé (3.3) étant maintenue constante pendant une émission du bruit synthétique modulé (3.3),
**caractérisé en ce que**
le bruit synthétique non modulé (3.1) est conçu sous forme de bruit 1/f et est prémodulé avant une modulation par l'au moins un filtre (5) et/ou amplificateur (6) dépendant du paramètre (4) de véhicule à l'aide d'au moins un filtre statique (7),
le bruit synthétique non modulé (3.1) étant prémodulé à l'aide de l'au moins un filtre statique (7) de telle sorte que le bruit synthétique prémodulé (3.2) comprend au moins deux signaux acoustiques (8.1, 8.2), un premier signal acoustique (8.1) présentant une première largeur spectrale (SB1), un second signal acoustique (8.2) présentant une seconde largeur spectrale (SB2) et la première largeur spectrale (SB1) correspondant à une plage de fréquences de 0 à 2200 Hz maximum et la seconde largeur spectrale (SB2) se situant dans une plage de fréquences supérieure à la première largeur spectrale (SB1), la seconde largeur spectrale (SB2) comprenant complètement une largeur spectrale d'au moins un bruit parasite (2) à masquer.

2. Procédé selon la revendication 1,
**caractérisé en ce**
**qu**'au moins un filtre (5) adaptatif est formé par un filtre passe-bas, une fréquence de coupure du filtre passe-bas dépendant d'une vitesse de déplacement du véhicule (1).

3. Procédé selon l'une des revendications 1 à 2,
**caractérisé en ce**
**qu'**un facteur d'amplification (f) d'au moins un amplificateur (6) adaptatif dépend d'une vitesse de déplacement du véhicule (1), le facteur d'amplification (f) prenant une valeur maximale dans au moins une plage de vitesses dans laquelle un bruit parasite (2) apparaît.

4. Procédé selon la revendication 3,
**caractérisé en ce que**
le facteur d'amplification (f) prend une valeur minimale à un intervalle prédéterminé avant le début et après la fin de la plage de vitesses dans laquelle le bruit parasite apparaît et en particulier augmente et diminue de manière continue de la valeur minimale à la valeur maximale.

5. Procédé selon l'une des revendications 1 à 4,
**caractérisé en ce que**
le bruit synthétique (3) subit, après la modulation par l'au moins un filtre (5) adaptatif et/ou un amplificateur (6), un retard de rétroaction, en particulier par une atténuation réglable, dont la fonction de transmission correspond à un filtre en peigne.

6. Procédé selon la revendication 5,
**caractérisé en ce**
**qu**'un temps de retard réciproque à une fréquence (F) du bruit parasite (2) à masquer est imposé au bruit synthétique (3) dans le retard de rétroaction.

7. Procédé selon l'une des revendications 1 à 6,
**caractérisé en ce**
**qu**'au moins un bruit synthétique (3) est réparti entre au moins deux haut-parleurs (10) pour l'émission dans le véhicule (1).

8. Procédé selon la revendication 7,
**caractérisé en ce que**
l'au moins un bruit synthétique (3) est émis par l'intermédiaire d'au moins deux haut-parleurs (10) de telle sorte qu'une position d'une source de bruit (11) apparente, dont le bruit synthétique (3) semble provenir pour un occupant du véhicule, est positionnée dans un habitacle (12) de véhicule en un emplacement fixe, en particulier à l'aide d'un algorithme ambisonique.

9. Procédé selon la revendication 8,
**caractérisé en ce**
**qu**'au moins deux bruits synthétiques (3) pourvus d'un retard de rétroaction sont émis dans le véhicule (1) et les positions apparentes de leurs sources de bruit (11) sont positionnées en différents endroits dans l'habitacle (12) de véhicule, les deux bruits synthétiques (3) présentant un temps de retard de rétroaction différent l'un de l'autre.

10. Véhicule (1) comportant une unité de calcul (13), au moins un capteur (14) pour la détection d'une vitesse du véhicule et au moins un haut-parleur (10),
**caractérisé en ce que**
l'unité de calcul (13), le capteur (14) et le haut-parleur (10) sont disposés pour la mise en oeuvre d'un procédé selon l'une des revendications 1 à 9.
